Europäisches Patentamt

European Patent Office

Office européen des brevets

(19)

(11) **EP 1 098 204 B1**

(12) **EUROPEAN PATENT SPECIFICATION**

(45) Date of publication and mention
of the grant of the patent:
**17.08.2005 Bulletin 2005/33**

(51) Int Cl.7: **G01R 33/46**

(21) Application number: **99119845.8**

(22) Date of filing: **07.10.1999**

(54) **Single-transition-to-single-transition coherence transfer by cross-polarization: quantitation of cross-correlation effects in NMR**

Einzelübergang zu Einzelübergang Kohärenztransfer durch Kreuzpolarisation: Quantisierung von Kreuzkorrelationseffekten in der Kernspinresonanz

Transfert de cohérence parmi des transitions isolées par polarisation croisée: quantification d'effets de correlation croisée dans la résonance magnétique nucléaire

(84) Designated Contracting States:
**CH DE FR GB LI**

(43) Date of publication of application:
**09.05.2001 Bulletin 2001/19**

(73) Proprietor: **Bruker BioSpin AG**
**8117 Fällanden (CH)**

(72) Inventors:
• **Ferrage, Fabien**
**F-75013 Paris (FR)**
• **Eykyn, Thomas R.**
**Winchester SO23 7DA (GB)**
• **Bodenhausen, Geoffrey**
**F-75014 Paris (FR)**

(74) Representative: **Kohler Schmid Möbus**
**Patentanwälte**
**Ruppmannstrasse 27**
**70565 Stuttgart (DE)**

(56) References cited:
• **ERMAKOV V L ET AL: "Coherence transfer in three-level systems: controlled violation of adiabaticity and antiparallel double resonant irradiation" JOURNAL OF CHEMICAL PHYSICS, 1 JULY 1995, USA, vol. 103, no. 1, pages 136-143, XP002129264 ISSN: 0021-9606**
• **CHIARPARIN E ET AL: "Selective cross-polarization in solution state NMR" MOLECULAR PHYSICS, 10 DEC. 1998, TAYLOR & FRANCIS, UK, vol. 95, no. 5, pages 759-767, XP000872079 ISSN: 0026-8976**

**Description**

The invention refers to a method of nuclear magnetic resonance (=NMR) spectroscopy for achieving selective single-transition-to-single-transition cross-polarization (ST-CP) between two selected transitions in systems with two or more coupled spins by irradiating radio frequency (=RF) pulses to a sample in a homogeneous magnetic field in z-direction.

**I. INTRODUCTION**

Cross-correlated relaxation phenomena have become important for the characterization of isotopically labelled macromolecules by solution-state NMR. The measurement of cross-correlated relaxation rates has enabled the direct measurement[1-4] of bond angles subtended by pairs of internuclear bond vectors in proteins without need to resort to empirical Karplus-type relationships. These angular constraints may also be used in conformational studies of small ligands bound to macromolecules using transferred cross-correlated relaxation,[5-7] in analogy to transferred NOE. Measurement of $^{15}$N relaxation rates in both laboratory and rotating frames have yielded insight into exchange effects[8] and dynamic behaviour[9] of proteins in solution, the primary sources of relaxation in proteins being the chemical shift anisotropy (CSA) of the heteronuclei $^{13}$C or $^{15}$N and dipole-dipole (DD) coupling with directly bound protons.

Structural and dynamic studies become problematic with increasing molecular size due to increased transverse relaxation rates. A number of methods have been introduced to circumvent these effects. Transverse relaxation rates of amide protons may be reduced by exchanging all carbon-bound protons by deuterium. Alternatively one may use the interference between the CSA and DD interactions which leads to differential line narrowing[10-12] of the individual multiplet components. In transverse relaxation optimized spectroscopy (TROSY)[13] this effect is exploited by selecting the slowly-relaxing component in undecoupled heteronuclear correlation experiments. Improved versions[14-16] using single-transition-to-single-transition coherence transfer yield a $\sqrt{2}$ sensitivity enhancement and have been employed[17] to measure $^{13}$C relaxation rates in RNA and DNA bases. In general, coherence transfer is achieved via a series of INEPT-like transfers which limit the size of the proteins that may be studied. An avenue[18] to study macromolecules of increasing molecular mass employs a combination of cross-correlated relaxation and evolution under scalar coupling to achieve polarization transfer.

Mehring, Wolff and Stoll[19] have shown that it is possible to transfer coherence in a three-level system (such as occurs for deuterium with a non-vanishing quadrupole interaction) by simultaneous irradiation of two connected single-quantum transitions. This idea has been extended[20] to achieve coherence transfer between allowed and forbidden single- and multiple-quantum coherences.

It is an object of the invention to present a general method for studying differential relaxation of different multiplet components.

With the approach according to the present invention, one may also transfer coherence by selective cross-polarization between two selected transitions in a four-level system consisting of scalar coupled spins $I = 1/2$ and $S = 1/2$ in isotropic solution. This is achieved by the following steps:

1) Choose RF pulses suitably shaped for a selective excitation experiment with an RF amplitude that is weaker than the scalar coupling constant $J_{IS}$ of the I and S spin systems;

2) Simultaneously stimulate a pair of connected transitions of the I and S spin systems;

3) Record the response for the said selective excitation experiment and observe different pairs of connected transitions.

With the inventional method, selective single-transition-to-single-transition cross-polarization (ST-CP) can be achieved in heteronuclear scalar-coupled two-spin systems, such as amide $^{15}$N-$^{1}$H groups, by employing RF amplitudes that are much weaker than the scalar coupling constant $J_{NH}$, and by simultaneously irradiating a pair of connected transitions. Each of the four multiplet components in an undecoupled heteronuclear correlation spectrum may be observed in turn. The transfer benefits from differential line narrowing due to interference between the $^{15}$N chemical shift anisotropy and $^{15}$N-$^{1}$H dipolar coupling, which is clearly observed in $^{15}$N-labelled human ubiquitin at 600 MHz.

The spin system can be kept in isotropic or anisotropic solution during the experiment, depending on the desired environment of the sample material.

The intensities of the observed signals may depend upon the chosen pair of connected transitions because of cross-correlated relaxation effects.

An advantageous variant of the inventional method employs semi-selective cross-polarization during a preparation period $\tau_1$ to transfer coherence through the scalar coupling from both doublet components of the selected source spin I to the two doublet components of the directly bound second spin S.

This may be improved by using matched RF fields with amplitudes of the order of the heteronuclear coupling constant $J_{IS}$.

In a preferred variant, the method according to the present invention may be characterised by applying the following pulse sequence to the spin system I and S :

a) irradiating a $\pi/2$ RF pulse acting on spins I with a phase-cycle $\Phi_1$ = y, y, -y, -y;

b) applying two RF fields with matched amplitudes of $\omega_1^I/2\pi = \omega_1^S/2\pi$ and carrier frequencies positioned at the midpoints of the I and the S doublets during a preparation time period $\tau_1 = J_{IS}^{-1}$;

c) irradiating a n/2 RF pulse acting on spins S with a phase-cycle $\Phi_2$ = y, -y, -y, y

d) destroying any residual transverse magnetization by applying a first spoil gradient pulse $G_1$ followed by a proton $\pi/2$ pulse and subsequently by applying a second spoil gradient pulse $G_2$;

e) irradiating a $\pi/2$ pulse acting on the spins S;

f) applying two RF fields with matched amplitudes of $\omega_1^I/2\pi = \omega_1^S/2\pi$ for single-transition-to-single-transition cross-polarization, on-resonance with any chosen pair of connected transitions during a second time period $\tau_2$, the amplitudes of the RF fields being reduced with respect to the amplitudes in step b)

g) using a receiver phase-cycling $\Phi_{rec}$ = x, -x, x -x.

This can be further improved by inserting a suitable relaxation delay at a time point (a) before the ST-CP interval $\tau_2$ to monitor the relaxation behaviour of the spin S coherences whilst observing the spin I doublet components.

Another improvement of this method is characterised by inserting a Carr-Purcell-Meiboom-Gill (CPMG) multiple refocussing sequence at time point (a) before the ST-CP interval $\tau_2$ to monitor the relaxation behaviour of the spin S coherences whilst observing the spin I doublet components.

It may be also of advantage using a Carr-Purcell-Meiboom-Gill (CPMG) spin echo sequence for $T_2$ measurements whereby the intervals between the $\pi$ pulses of the CPMG pulse train are set to $2\tau = n/J_{IS}$, where n is an integer.

Alternatively, the method according to the present invention may be modified by inserting a spin-lock field at time point (a) before the ST-CP interval $\tau_2$ for $T_{1\rho}$ measurements.

## II. THEORY

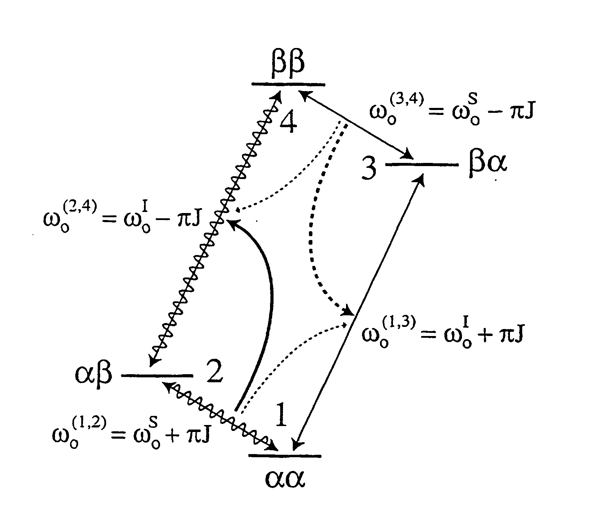

Figure 1 shows the energy-level diagram for a scalar coupled two-spin system IS. In analogy to the case of deuterium,[19,20] it is possible to transfer coherence by simultaneously irradiating two connected transitions. Spin-state selective coherence transfer in a four-level system relies on irradiating the two transitions in a highly selective manner. In an ideal case, the presence of the fourth energy level should not affect the cross-polarization pathway of interest.

In the theory outlined below we consider cross-polarization from the coherence $I_x^{(1,2)}$ associated with a nitrogen transition to the progressively connected proton coherence $I_x^{(2,4)}$. In the presence of two RF fields which are on-resonance for the selected proton and nitrogen transitions the Hamiltonian in the laboratory frame may be written as

$$H^{lab} = \omega_0^I I_z + \omega_0^S S_z + 2\pi J_{IS} I_z S_z$$

$$+\omega_1^I \cos(\omega_0^{(2,4)}t)I_x + \omega_1^I \sin(\omega_0^{(2,4)}t)I_y$$

$$+\omega_1^S \cos(\omega_0^{(1,2)}t)S_x + \omega_1^S \sin(\omega_0^{(1,2)}t)S_y, \tag{1}$$

where the RF amplitudes are given by $\omega_1^I = -\gamma^I B_1^I$ and $\omega_1^S = -\gamma^S B_1^S$. For clarity the initial RF phases have been assumed to be zero. It is convenient to recast this Hamiltonian in terms of single transition operators.[21-22] The proton and nitrogen doublets, respectively, are given by

$$I_x = I_x^{(1,3)} + I_x^{(2,4)} \text{ and } S_x = I_x^{(1,2)} + I_x^{(3,4)}. \tag{2}$$

The resonance frequencies of these transitions result from the Zeeman interaction and the scalar coupling. We define an interaction representation using the transformation[23] $U_0 = \exp(-iH_0 t)$ where $H_0 = \omega_0^I I_z + \omega_0^S S_z + 2\pi J_{IS} I_z S_z$. The laboratory frame Hamiltonian of Eq. (1) becomes

$$H^{ref} = \omega_1^I I_x^{(2,4)} + \omega_1^S I_x^{(1,2)} + \omega_1^I I_x^{(1,3)} \cos(2\pi J_{IS}t) + \omega_1^I I_y^{(1,3)} \sin(2\pi J_{IS}t) + \omega_1^S I_x^{(3,4)}\cos(2\pi J_{IS}t) + \omega_1^S I_y^{(3,4)} \sin(2\pi J_{IS}t)$$

(3)

For very weak RF fields ($\omega_1^I$, $\omega_1^S \ll 2\pi J_{IS}$) one may neglect the oscillating components by invoking the secular approximation. Thus, as an initial approximation, we consider only the first two terms in the Hamiltonian. These terms are responsible for on-resonance coherence transfer. We shall see later that the other terms can lead to off-resonance coherence transfer if the amplitude of the spin-lock fields is not much weaker than the coupling constant.

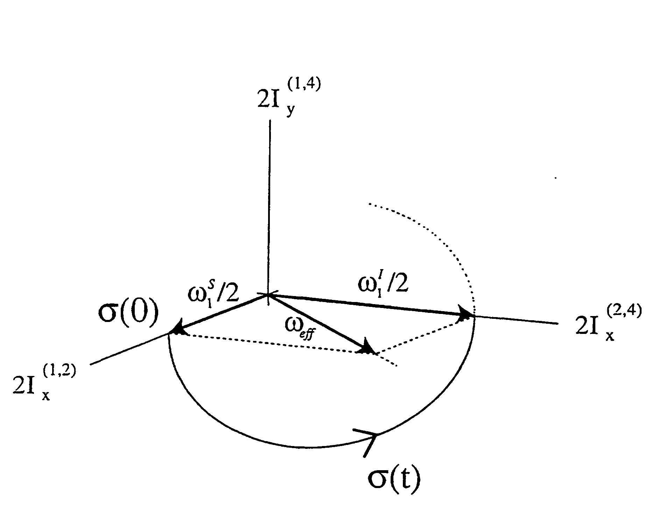

Figure 2 shows the evolution of the density operator under the influence of the Hamiltonian in Eq. (3), truncated to include only the first two terms. Cross-polarization is described by a rotation of the initial vector $\sigma(0) = I_x^{(1,2)}$ onto $I_x^{(2,4)}$ about an effective field $\omega_{eff} = \sqrt{(\omega_1^I/2)^2 + (\omega_1^S/2)^2}$. This amounts to a rotation confined to a three-dimensional subspace of the full sixteen-dimensional Liouville space,

$$\{2I_x^{(1,2)}, 2I_x^{(2,4)}, 2I_y^{(1,4)}\}$$

(4)

The evolution of the density operator in the case of matched RF fields is given by,

$$\sigma(t) = \frac{1}{2}(1 + \cos\omega_{eff}t)I_x^{(1,2)} + \frac{1}{2}(1 - \cos\omega_{eff}t)I_x^{(2,4)} - \frac{1}{\sqrt{2}}(\sin\omega_{eff}t)I_y^{(1,4)}$$

(5)

In contrast to conventional semi-selective cross-polarization[25], the transfer does not depend on the coupling constant $J_{IS}$. The efficiency of the transfer is a maximum when the Hartmann-Hahn condition is fulfilled ($\omega_1^I = \omega_1^S$). It should be noted that $tr(I_x^{(2,4)} I_x^{(2,4)}) = 1/2$, corresponding to one component of the doublet. In the absence of relaxation, the maximum expectation value of the observable $\langle I_x^{(2,4)} \rangle$ is therefore 1/2, which occurs for a spin-lock duration of $\tau = \pi/\omega_{eff}$. Thus RF field amplitudes $\omega_1^I/2\pi = \omega_1^S/2\pi = 26$ or 11 Hz yield optimum transfer times of 27 or 64 ms respectively.

One should note that coherence transfer processes (1,2) → (2,4) or (1,3) → (3,4) between progressively connected transitions in the two subsystems (1,2,4) and (1,3,4) occur via the double quantum transition $I^{(1,4)}_y$ whereas coherence transfer processes (1,2) → (1,3) or (3,4) → (2,4) between regressively connected transitions in the two subsystems (1,2,3) and (2,3,4) occur via the zero quantum transition $I^{(2,3)}_y$.

Equation (5) gives us insight into the overall time dependence of the density operator. However, in systems such as $^{15}N$-$H^N$ in proteins, the scalar coupling is usually of the order of $J_{NH} = 95$ Hz, so that the secular approximation may be violated and the oscillating components in the Hamiltonian may have to be considered. Computer simulations have been carried out using subroutines of GAMMA[24] and the complete Hamiltonian of Eq. (3). Although the dominant feature is due to the transfer function given in Eq. (5), the signals are modulated by additional frequencies. A frequency component corresponding to the coupling constant $2\pi J_{IS}$ represents a parasitic transfer (light dashed arrows in Fig. 1) which is of the order of 5 % of the maximum intensity of the on-resonance transfer. A second, more pronounced, low-frequency modulation may also be observed. The frequency of this modulation increases with increasing RF field amplitude. It is found that this additional modulation does not have a detrimental effect on the efficiency of cross-polarization provided $\omega_1/2\pi \le J_{IS}/3$.

## III. RELAXATION

Single-transition-to-single-transition cross-polarization provides interesting insight into relaxation occurring during transfer. We have chosen a phenomenological approach by constructing a Liouvillian superoperator which includes coherent interactions given by the Hamiltonian in Eq. (3) and relaxation. The relaxation superoperator is diagonal if cross-relaxation is neglected, with diagonal elements composed of the self-relaxation rates of each coherence.

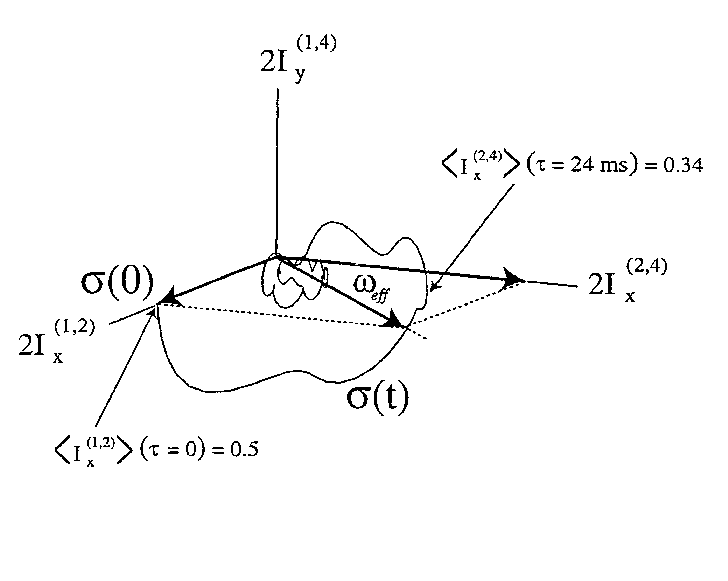

Figure 3 shows the trajectory of the density operator as a function of time. The relaxation times are representative of an amino acid in the rigid core of a small protein. All density operator components are attenuated by relaxation, and the vector in Fig. 3 follows a helical trajectory around $\omega_{eff}$. One may note that, even for a protein, the efficiency of cross-polarization for a contact time $\tau = 24$ ms with RF field amplitudes of 26 Hz is about 68 % of the amplitude expected in the absence of relaxation.

It is also important to note that, due to the spin-state selective nature of the transfer, the efficiency will be governed by the individual relaxation rates for each coherence. Thus cross-polarization between slowly relaxing components will be more efficient than between rapidly relaxing components. This is another manifestation of the so-called TROSY effect.

## IV. EXPERIMENT

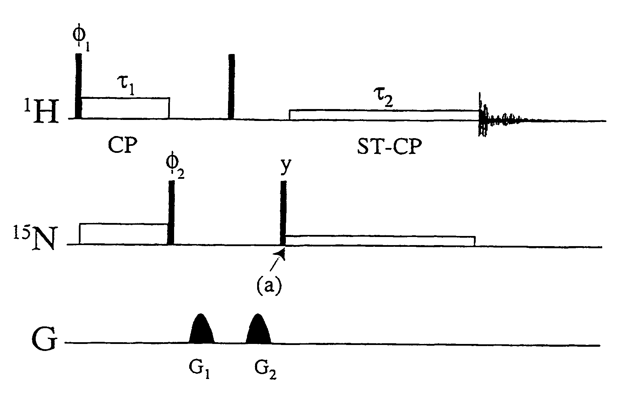

The preparation period $\tau_1$ in Fig. 4 employs semi-selective cross-polarization[25-26] to transfer coherence through the scalar coupling from both doublet components of a selected source spin $H^N$ to the two doublet components of the directly bound $^{15}N$. This may be achieved using matched fields with amplitudes of the order of the heteronuclear coupling to overcome problems with RF field inhomogeneity[25]. We subsequently rotate the resulting $S_x$ magnetization along the z axis and destroy any residual transverse magnetization, notably that of water, with two spoil gradients and a proton pulse. After another $\pi/2$ applied to $^{15}N$ we have both nitrogen doublet components $S_x = I_x^{(1,2)} + I_x^{(3,4)}$ at time point (a). We then apply two low-amplitude fields for single-transition-to-single-transition cross-polarization, on-resonance with any chosen pair of connected transitions. This yields a spectrum composed of a proton doublet whereby the on-resonance doublet component displays the build-up behaviour given by Eq. (5). The other off-resonance doublet component is modulated as a function of $\tau_2$ at a frequency corresponding to the coupling constant. For example, if one chooses the on-resonance transfer $I_x^{(1,2)} \to I_x^{(2,4)}$ then the off-resonance transfer would be $I_x^{(3,4)} \to I_x^{(1,3)}$, corresponding to the component which is diagonally opposed in the HSQC spectrum.

One can modify the pulse sequence in Fig. 4 to measure $T_{1\rho}$ or $T_2$ relaxation times for the individual nitrogen doublet components. If one inserts a suitable relaxation delay at time point (a) in Fig. 4 then the relaxation behaviour of the nitrogen coherences may be monitored whilst observing the proton doublet components. For $T_{1\rho}$ measurements a spin-lock field can be inserted. For $T_2$ measurements a Carr-Purcell-Meiboom-Gill (CPMG) spin echo sequence can be used. The intervals between the $\pi$ pulses of the CPMG pulse train are set to $2\tau = n/J_{IS}$ where n is an integer. This averages the auto-relaxation rates of in-phase $S_x$ and antiphase $2S_xI_z$ coherences as the scalar coupling remains active during these intervals.[27] In this case the effective relaxation matrix reduces to diagonal form with each doublet component relaxing mono-exponentially at a rate $R_{av} \pm \delta$ where $R_{av} = (\rho_N + \rho_{NH})/2$, $\delta$ is the CSA-dipole cross correlated relaxation rate and $\rho_N$ and $\rho_{NH}$ are the autorelaxation rates of in- and antiphase terms $S_x$ and $2S_xI_z$. In the case of $T_1$ measurements, where there is no evolution under the scalar coupling, the relaxation will in general become multiexponential.[28]

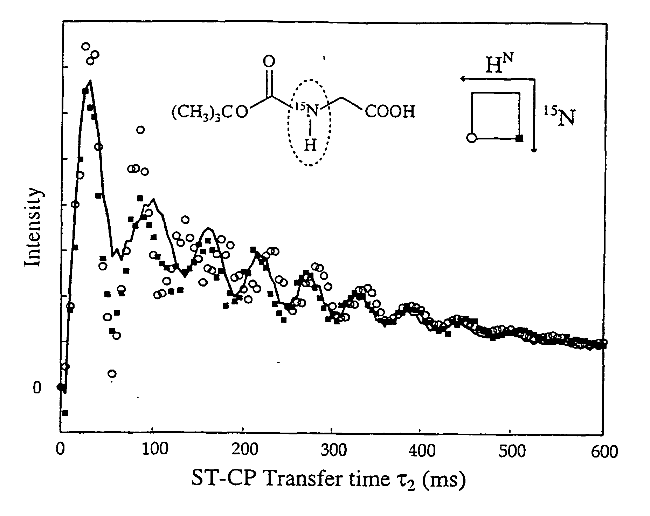

A 100 mM sample of $^{15}N$ enriched boc-protected glycine in DMSO was used to illustrate the transfer process. This is a convenient test sample and may be considered as an isolated $^{15}N$-$H^N$ fragment ($J_{NH} \approx 94$ Hz) within a small molecule with correspondingly long $T_2$'s. All experiments were performed on a Bruker DRX 600 MHz spectrometer with a TBI probe equipped with triple axis gradients. Figure 5 shows the signal intensity due to on-resonance ST-CP as a function of the spin lock duration $\tau_2$. For clarity only two curves are displayed which correspond to coherence transfer from the high-frequency nitrogen doublet component $I_x^{(1,2)}$ to one of the proton doublet components. Since the $T_2$'s of the two proton doublet components are almost equal, the differences in the two curves are primarily due to the fact that the density operator passes through states with different relaxation times, the progressive connectivity being mediated via double quantum coherence whereas the regressive connectivity passes through zero quantum coherence. The other two cross-polarization paths from the low-frequency nitrogen coherence $I_x^{(3,4)}$ (not shown) are qualitatively similar. Also displayed is a simulation of the evolution of the density operator, using a Liouvillian superoperator composed of the sum of coherent and relaxation superoperators. Relaxation times $T_{1\rho}^S$ and $T_{1\rho}^I$ for the nitrogen and proton transitions may be measured by modifying the pulse sequence, as described previously. The decay yields a value of $1\rho = 2.86$ s for both nitrogen transitions. If a proton spin-lock field is inserted immediately before aquisition, the decay yields a value of $T_{1\rho}^I = 383$ ms for both proton transitions. One may then vary the relaxation time of the zero- or double-quantum transition empirically until an agreement with the experiments is attained.

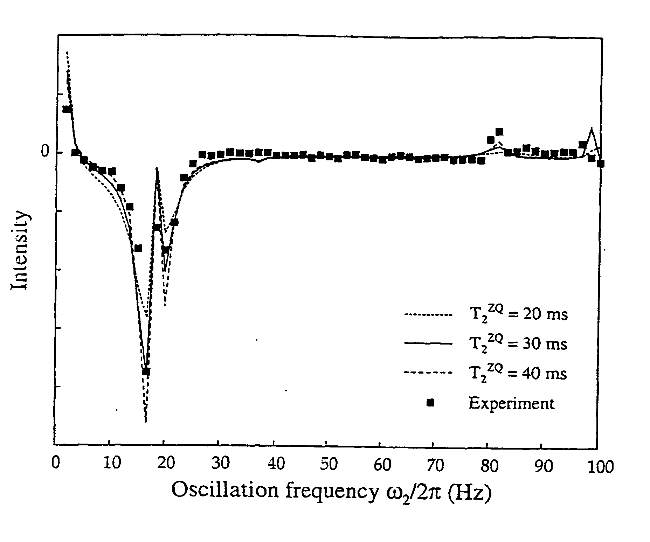

It is instructive to take a Fourier transform to unravel the different frequency components in the build-up curves of Fig. 5. This was carried out using MATLAB and is shown in Fig. 6. The most intense peak is centered at $\omega_2 = 18$ Hz corresponding to RF field strengths $\omega_1^S/2\pi = \omega_1^I/2\pi = 26$ Hz ($\omega_{eff}/2\pi = 18.4$ Hz). Additional fine structure may be observed giving evidence of a low-frequency modulation which arises due to a breakdown in the secular approximation. One may also observe a doublet centered at the coupling constant $J_{NH} = 94$ Hz corresponding to a residual 'parasitic' transfer from the other nitrogen doublet component. These effects are consistent with simulations. Also displayed in Fig. 6 are simulations in which the relaxation time $T_2^{ZQC}$ of the zero quantum coherence $I_x^{(2,3)}$ is varied. The best fit may be observed for $T_2^{ZQC} \approx 30$ ms.

## V. APPLICATION

The principles of ST-CP were applied to relaxation measurements in a 1.5 mM sample of $^{15}N$-labeled human ubiquitin (VLI Research) in $H_2O : D_2O = 9 : 1$ buffered at pH = 4.5 with 20 mM perdeuterated acetic acid at a temperature of 303 K and a static field of 14 T.

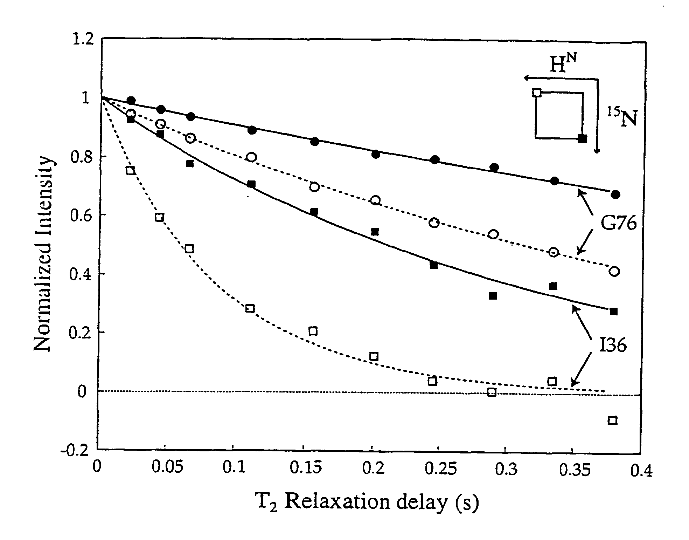

Results of $T_2^S$ measurements for $^{15}N$ are displayed in Fig. 7 where we have chosen two different amide groups in the protein, I36 and G76. One may clearly observe the differential relaxation responsible for the TROSY effect in the nitrogen dimension of an undecoupled HSQC. One may also observe clear differences in mobility with I36 being located in the more rigid core of the protein whereas G76 is the final residue of the highly mobile C-terminus. It is interesting to note that the differential relaxation of the two doublet components is quite pronounced even in a small protein such as ubiquitin at 14 T and at ambient temperature.

## VI. CONCLUSIONS

It has been shown that one may achieve single-transition-to-single-transition coherence transfer in a scalar-coupled two-spin system by cross polarization. The method proposed is quite general provided the selectivity is sufficient to consider the relevant three-level subsystem to be isolated from all other energy levels. The method will be particularly useful to study differential relaxation of different multiplet components. The principles outlined here may cast new light on a variety of cross-correlated relaxation phenomena.

### Figure Captions

FIG. 1. Energy-level diagram for a scalar-coupled two-spin system IS, such as is found in backbone amide N-H groups of $^{15}$N labelled proteins and peptides. The nitrogen doublet components correspond to transitions (1,2) and (3,4). The proton doublet components correspond to transitions (1,3) and (2,4). Also shown is a schematic representation of single-transition-to-single-transition cross-polarization (ST-CP) transfer. The main pathways correspond to on-resonance (thick solid arrow) and off-resonance transfer (thick dashed arrow). Also shown are undesired parasitic transfer pathways (thin dashed arrows).

FIG. 2. The evolution of the density operator during single-transition-to-single-transition cross-polarization corresponds to a rotation within a three-dimensional subspace of the complete 16 dimensional Liouville space. Coherence transfer from $I_x^{(1,2)}$ to $I_x^{(2,4)}$ can be achieved by a rotation of the density operator about an effective field $\omega_{eff}$ and passes via double quantum coherence $I_y^{(1,4)}$, as shown in Eq. (7).

FIG. 3. Simulated evolution of the density operator using the complete Hamiltonian of Eq. (3) and a relaxation superoperator as described in the text. RF field amplitudes are $\omega_1/2\pi = \omega_1^I/2\pi = \omega_1^S/2\pi \approx 26$ Hz. The relaxation times used were $T_{1\rho}^I = 90$ ms, $T_{1\rho}^S = 415$ ms and $T_2^{DQC} = 30$ ms which are representative of an amino acid residue in the rigid core of a small protein. At $\tau = 24$ ms, one obtains a state with an optimum expectation value of $\langle I_x^{(2,4)}\rangle = 0.34$.

FIG. 4. Pulse sequence used for coherence transfer by cross-polarization. The first semi-selective cross-polarization (CP) period has a duration $\tau_1 = J_{IS}^{-1} = 10.9$ ms and matched amplitudes of $\omega_1^I/2\pi = \omega_1^S/2\pi \approx 70$ Hz. The carrier frequencies are positioned at the midpoints of the proton and nitrogen doublets. During the second, selective single-transition-to-single-transition cross-polarization (ST-CP) period $\tau_2$, the matched amplitudes are reduced to $\omega_1^I/2\pi = \omega_1^S/2\pi \approx 26$ Hz and the carrier frequencies moved to any two connected transitions which appear in the undecoupled multiplet, e.g. $\omega_0^{(1,2)} = \omega_0^S + \pi J$ or $\omega_0^{(3,4)} = \omega_0^S - \pi J$ and $\omega_0^{(1,3)} = \omega_0^I + \pi J$ or $\omega_0^{(2,4)} = \omega_0^I - \pi J$ ($\omega_0^I = -\gamma_I B_0 < 0$ for $^1$H, $\omega_0^S = -\gamma_S B_0 > 0$ for $^{15}$N). The phase-cycling is: $\Phi_1 = y, y, -y, -y, \Phi_2 = y, -y, -y, y$, receiver $\Phi_{rec} = x, -x, x, -x$.

FIG. 5. Signal intensity of selected doublet components in boc-protected $^{15}$N enriched glycine as a function of the spin-lock duration $\tau_2$ (see Fig. 4). The experimental points correspond to cross-polarization from the high-frequency nitrogen transition $I_x^{(1,2)}$ to the low-frequency $I_x^{(1,3)}$ (■) or to the high-frequency $I_x^{(2,4)}$ (○) proton components (see schematic representation of the undecoupled HSQC multiplet and the corresponding resonance frequencies). Also displayed is a simulation of the (■) transfer taking into account relaxation within the three-dimensional subspace shown in Fig. 2, as described in the text. The experimental curves comprise 120 points, each of which was acquired with 16 scans at 303 K and 14 T.

FIG. 6. Fourier transform ($\omega_2$) of the oscillatory $\tau_2$ time dependence of ST-CP. Experimental points are calculated from the data of Fig. 5. Also displayed are the Fourier transforms of three simulations where the relaxation time $T_2^{ZQC}$ of the zero quantum coherence $I_y^{(2,3)}$ has been varied.

FIG. 7. Experimental $T_2$ decay curves of different nitrogen doublet components in human ubiquitin, obtained by inserting a Carr-Purcell-Meiboom-Gill (CPMG) multiple refocussing sequence before the ST-CP interval $\tau_2$ of Fig. 4. For illustration two different amino acids (I36 and G76) are displayed. Filled symbols correspond to on-resonance cross-polarization from the high-frequency nitrogen transition $I_x^{(1,2)}$ to the low-frequency proton component $I_x^{(1,3)}$. Empty symbols correspond to off-resonance cross-polarization from the low-frequency nitrogen transition $I_x^{(3,4)}$ to the high-frequency proton component $I_x^{(2,4)}$. A schematic representation of the undecoupled HSQC multiplet indicates the on- and off-resonance components. Relaxation rates for both doublet components are thus taken from a single series of experiments with a total experiment time of 20 mins for each amide residue. The ST-CP cross-polarization transfer time was $\tau_2 = 26$ ms for field strengths of $\omega_1^I/2\pi = \omega_1^S/2\pi = 26$ Hz, which yields the maximum intensity for both the on-resonance and off-resonance components. Curve fits correspond to mono-exponential decays with $T_2^S$: (●) = 1.04 s, (○) = 457 ms, (■) = 306 ms, (□) = 87 ms. Each point was acquired with 64 scans at 303 K and 14 T.

**References**

[1]B. Reif, M. Hennig and C. Griesinger, Science, **276**, 1230 (1997).

[2]D. Yang, R. Konrat, L.E. Kay, J. Am. Chem. Soc. **119**, 11938 (1997).

[3] D. Yang, K.H. Gardner, L.E. Kay, J. Biomol. NMR **11**, 213 (1998).

[4]E. Chiarparin, P. Pelupessy, R. Ghose and G. Bodenhausen, J. Am. Chem. Soc. **121**, 6876 (1999).

[5]T. Carlomagno, I.C. Felli, M. Czech, R. Fischer, M. Sprinzl and C. Griesinger, J. Am. Chem. Soc. **121**, 1945 (1999).

[6] M.J.J. Blommers, W. Stark, C.E. Jones, D. Head, C.E. Owen and W. Jahnke, J. Am. Chem. Soc. **121**, 1949 (1999).

[7]I.C. Felli, C. Richter, C. Griesinger, H. Schwalbe, J. Am. Chem. Soc. **121**, 1956 (1999).

[8]C.D. Kroenke, J.P. Loria, L.K. Lee, M. Rance and A.G. Palmer III, J. Am. Chem. Soc. **120**, 7905 (1998).

[9]I.C. Felli, H. Desvaux and G. Bodenhausen, J. Biomol. NMR **12**, 509 (1998).

[10]M. Guéron, J.L. Leroy, and R.H. Griffey, J. Am. Chem. Soc. **105**, 7262 (1983).

[11]M. Goldman, J. Magn. Reson. **60**, 437 (1984).

[12]T.C. Farrar and T.C. Stringfellow, *Encyclopedia of NMR,* D.M. Grant and R.K. Harris (eds.) Wiley, New York, **6**, 410 (1996).

[13]K. Pervushin, R. Riek, G. Wider and K. Wüthrich, Proc. Natl. Acad. Sci. USA **94**, 12366 (1997).

[14]K. Pervushin, G. Wider and K. Wüthrich, J. Biomol. NMR **12**, 345 (1998).

[15]J. Weigelt, J. *Am. Chem. Soc.* **120**, 10778-10779 (1998).

[16]P. Andersson, A. Annila and G. Otting, J. Magn. Reson. **133**, 364 (1998).

[17]J. Boisbouvier, B. Brutscher, J.-P. Simorre and D. Marion, J. Biomol. NMR **14**, 241 (1999).

[18]R. Riek, G. Wider, K. Pervushin and K. Wüthrich, Proc. Natl. Acad. Sci. USA **96**, 4918 (1999).

[19]M. Mehring, E.K. Wolff and M.E. Stoll, J. Magn. Reson. **37**, 475 (1980).

[20]V.L. Ermakov and G. Bodenhausen, J. Chem. Phys. **103**, 136 (1995).

[21]A. Wokaun and R.R. Ernst, J. Chem. Phys. **67**, 1752 (1977).

[22]S. Vega, J. Chem. Phys. **68**, 5518 (1978).

[23]M. Goldman, *Quantum Description of High-Resolution NMR in Liquids* (Oxford University Press, Oxford 1988).

[24]S.A. Smith, T.O. Levante, B.H. Meier, and R.R. Ernst, J. Magn. Reson. A, **106**, 75 (1994).

[25]E. Chiarparin, P. Pelupessy and G. Bodenhausen, Mol. Phys. **95**, 759 (1998).

[26]P. Pelupessy and E. Chiarparin, Concepts Magn. Reson. submitted.

[27]T. Meersmann and G. Bodenhausen, Chem. Phys. Lett. **257**, 374 (1996).

[28]B. Brutscher, N.R. Skrynnikov, T. Bremi, R. Brüschweiler and R.R. Ernst, J. Magn. Reson. **130**, 346 (1998).

**Claims**

1. A method of nuclear magnetic resonance (=NMR) spectroscopy for achieving selective single-transition-to-single-transition cross-polarization (ST-CP) between two selected transitions in systems with two or more coupled spins by irradiating radio frequency (=RF) pulses to a sample in a homogeneous magnetic field in z-direction comprising the following steps:

    1) Choose RF pulses suitably shaped for a selective excitation experiment with an RF amplitude that is weaker than the scalar coupling constant $J_{IS}$ of the I and S spin systems;

    2) Simultaneously stimulate a pair of connected transitions of the I and S spin systems;

    3) Record the response for the said selective excitation experiment and observe different pairs of connected transitions.

2. The method according to claim 1, **characterised in that** the spin system is kept in isotropic or anisotropic solution during the experiment.

3. The method according to claim 1 or 2 **characterised in that** the intensities of the observed signals depend upon the chosen pair of connected transitions because of cross-correlated relaxation effects.

4. The method according to any one of the preceding claims, **characterised by** employing semi-selective cross-polarization during a preparation period $\tau_1$ to transfer coherence through the scalar coupling from both doublet components of the selected source spin I to the two doublet components of the directly bound second spin S.

**5.** The method according to claim 4, **characterised by** using matched RF fields with amplitudes of the order of the heteronuclear coupling constant $J_{IS}$.

**6.** The method according to any one of the preceding claims,
**characterised by** applying the following pulse sequence to the spin system I and S :

a) irradiating a $\pi/2$ RF pulse acting on spins I with a phase-cycle $\Phi_1$ = y, y, -y, -y;

b) applying two RF fields with matched amplitudes of $\omega_1^I/2\pi = \omega_1^S/2\pi$ and carrier frequencies positioned at the midpoints of the I and the S doublets during a preparation time period $\tau_1 = J_{IS}^{-1}$;

c) irradiating a $\pi/2$ RF pulse acting on spins S with a phase-cycle $\Phi_2$ = y, -y, -y, y

d) destroying any residual transverse magnetization by applying a first spoil gradient pulse $G_1$ followed by a proton $\pi/2$ pulse and subsequently by applying a second spoil gradient pulse $G_2$;

e) irradiating a $\pi/2$ pulse acting on the spins S;

f) applying two RF fields with matched amplitudes of $\omega_1^I/2\pi = \omega_1^S/2\pi$ for single-transition-to-single-transition cross-polarization, on-resonance with any chosen pair of connected transitions during a second time period $\tau_2$, the amplitudes of the RF fields being reduced with respect to the amplitudes in step b)

g) using a receiver phase-cycling $\Phi_{rec}$ = x, -x, x -x.

**7.** The method according to claim 6, **characterised by** inserting a suitable relaxation delay at a time point (a) before the ST-CP interval $\tau_2$ to monitor the relaxation behaviour of the spin S coherences whilst observing the spin I doublet components.

**8.** The method according to claim 7, **characterised by** inserting a Carr-Purcell-Meiboom-Gill (CPMG) multiple refocussing sequence at time point (a) before the ST-CP interval $\tau_2$ to monitor the relaxation behaviour of the spin S coherences whilst observing the spin I doublet components.

**9.** The method according to claim 8 using a Carr-Purcell-Meiboom-Gill (CPMG) spin echo sequence for $T_2$ measurements, **characterised in that** the intervals between the $\pi$ pulses of the CPMG pulse train are set to $2\tau = n/J_{IS}$, where n is an integer.

**10.** The method according to claim 7, **characterised by** inserting a spin-lock field at time point (a) before the ST-CP interval $\tau_2$ for $T_{1\rho}$ measurements.

**Patentansprüche**

**1.** Verfahren zur Kernspinresonanz (NMR) Spektroskopie zum Erzielen einer selektiven single-transition-to-single-transition Kreuzpolarisierung (ST-CP) zwischen zwei ausgewählten Übergängen in Systemen mit zwei oder mehr gekoppelten Spins durch Bestrahlen einer Probe mit Hochfrequenz (HF)-Impulsen in einem homogenen Magnetfeld in z-Richtung, das folgende Schritte aufweist:

1) Auswählen von HF-Impulsen von geeigneter Form für ein selektives Anregungsexperiment mit einer HF-Amplitude, die schwächer ist als die skalare Kopplungskonstante $J_{IS}$ der I- und S-Spinsysteme;

2) gleichzeitiges Anregen eines Paars von verbundenen Übergängen der I- und S-Spinsysteme;

3) Aufzeichnen der Reaktion für das genannte selektive Anregungsexperiment und Beobachten von unterschiedlichen Paaren von verbundenen Übergängen.

**2.** Verfahren nach Anspruch 1, **dadurch gekennzeichnet, dass** das Spinsystem während des Experiments in einer isotropen oder anisotropen Lösung gehalten wird.

**3.** Verfahren nach Anspruch 1 oder 2, **dadurch gekennzeichnet, dass** die Intensitäten der beobachteten Signale aufgrund von kreuzkorrelierten Relaxationseffekten von dem gewählten Paar der verbundenen Übergänge abhängen.

**4.** Verfahren nach einem der vorhergehenden Ansprüche, **dadurch gekennzeichnet, dass** während einer Vorbereitungsdauer $\tau_1$ semi-selektive Kreuzpolarisierung angewandt wird, um Kohärenz durch die skalare Kopplung von beiden Duplett-Komponenten des gewählten Quellenspins I zu den zwei Duplett-Komponenten des direkt gebundenen zweiten Spins S zu übertragen.

**5.** Verfahren nach Anspruch 4, **dadurch gekennzeichnet, dass** passende HF-Felder mit Amplituden im Größenbereich der heteronuklearen Kopplungskonstante $J_S$ verwendet werden.

**6.** Verfahren nach einem der vorhergehenden Ansprüche, **dadurch gekennzeichnet, dass** die folgende Impulssequenz bei den Spinsystemen I und S angewandt wird:

a) Einstrahlen eines $\pi/2$ HF-Impulses, der auf Spins I mit einem Phasenzyklus $\Phi_1$=y,y,-y,-y wirkt;
b) Anlegen zweier HF-Felder während einer Vorbereitungszeitdauer $\tau_1=J_{IS}^{-1}$ mit passenden Amplituden von $\omega_1^I/2\pi = \omega_1^S/2\pi$ und Trägerfrequenzen, die an den Mittelpunkten der I und S-Dupletts angeordnet sind;
c) Einstrahlen eines $\pi/2$ HF-Impulses, der auf Spins S mit einem Phasenzyklus $\Phi_2$=y,-y,-y,y wirkt;
d) Zerstören jeglicher verbleibenden transversalen Magnetisierung durch Anlegen eines ersten Spoiler-Gradientenimpulses $G_1$, gefolgt von einem Proton-$\pi/2$-Impuls und anschließendem Anlegen eines zweiten Spoiler-Gradientenimpulses $G_2$;
e) Einstrahlen eines $\pi/2$-Impulses, der auf die Spins S wirkt;
f) Anlegen zweier HF-Felder mit passenden Amplituden von $\omega_1^I/2\pi = \omega_1^S/2\pi$ für single-transition-to-single-transition-Kreuzpolarisierung in Resonanz mit einem beliebigen gewählten Paar von verbundenen Übergängen während einer zweiten Zeitdauer $\tau_2$, wobei die Amplituden der HF-Feder in Bezug auf die Amplituden in Schritt b) reduziert sind;
g) Verwenden eines periodischen Empfänger-Phasenwechsels $\Phi_{rec}$= x,-x,x-x.

**7.** Verfahren nach Anspruch 6, **gekennzeichnet durch** Einführen einer geeigneten Relaxations-Verzögerung zu einem Zeitpunkt (a) vor dem ST-CP-Intervall $\tau_2$, um das Relaxationsverhalten der Spin S-Kohärenzen zu überwachen, während die Spin I-Duplett-Komponenten beobachtet werden.

**8.** Verfahren nach Anspruch 7, **gekennzeichnet durch** Einführen einer Carr-Purcell-Meiboom-Gill (CPMG) Mehrfach-Refokussiersequenz zum Zeitpunkt (a) vor dem ST-CP-Intervall $\tau_2$ zum Überwachen des Relaxationsverhaltens der Spin S Kohärenzen, während die Spin I-Duplett-Komponenten beobachtet werden.

**9.** Verfahren nach Anspruch 8 unter Verwendung einer Carr-Purcell-Meiboom-Gill (CPMG)-Spinechosequenz für $T_2$ Messungen, **dadurch gekennzeichnet, dass** die Intervalle zwischen den $\pi$ Impulsen des CPMG Impulszugs auf $2\tau$=n/$J_{IS}$ gesetzt werden, wobei n eine ganze Zahl ist.

**10.** Verfahren nach Anspruch 7, **gekennzeichnet durch** Einführen eines Spin-Lock-Felds zu einem Zeitpunkt (a) vor dem ST-CP-Intervall $\tau_2$ für $T_{1\rho}$ Messungen.

**Revendications**

**1.** Procédé de spectroscopie à résonance magnétique nucléaire (RMN) pour obtenir une polarisation croisée d'une seule transition vers une seule transition sélective (ST-CP) entre deux transitions sélectionnées dans des systèmes ayant deux ou plusieurs spins couplés en irradiant des impulsions à haute fréquence (HF) sur un échantillon dans un champ magnétique homogène dans une direction z comprenant les étapes suivantes :

1) choisir les impulsions HF de forme appropriée pour une expérimentation d'excitation sélective avec une amplitude HF qui est plus faible que la constante de couplage scalaire $J_{IS}$ des systèmes à spins I et S,
2) stimuler simultanément une paire de transitions reliées des systèmes à spins I et S,
3) enregistrer la réponse pour ladite expérimentation d'excitation sélective et observer les différentes paires de transitions reliées.

**2.** Procédé selon la revendication 1, **caractérisé en ce que** le système à spins est maintenu dans une solution isotrope ou anisotrope durant l'expérimentation.

**3.** Procédé selon la revendication 1 ou 2, **caractérisé en ce que** les intensités des signaux observés dépendent de la paire choisie de transitions reliées en raison des effets de relaxation à corrélation croisée.

4. Procédé selon l'une quelconque des revendications précédentes, **caractérisé par** l'emploi d'une polarisation croisée semi-sélective durant une période de préparation $\tau_1$ pour transférer la cohérence par l'intermédiaire du couplage scalaire depuis les deux composants doublets du spin source sélectionné I vers les deux composants doublets du second spin lié directement S.

5. Procédé selon la revendication 4, **caractérisé par** l'utilisation de champs HF adaptés présentant des amplitudes de l'ordre de la constante de couplage hétéronucléaire $J_{IS}$.

6. Procédé selon l'une quelconque des revendications précédentes, **caractérisé par** l'application de la séquence d'impulsions qui suit au système à spins I et S :

   a) irradier une impulsion HF $\pi/2$ sur des spins I avec une phase-cycle $\Phi_1 = y, y, -y, -y$,
   b) appliquer deux champs HF présentant des amplitudes adaptées $\omega_1^I/2\pi = \omega_1^S/2\pi$ et des fréquences porteuses positionnées à des points intermédiaires des doublets I et S durant une période de temps de préparation $\tau_1 = J_{IS}^{-1}$,
   c) irradier une impulsion HF $\pi/2$ agissant sur les spins S présentant une phase-cycle $\Phi_2 = y, -y, -y, y$,
   d) détruire toute magnétisation transversale résiduelle en appliquant une première impulsion à gradient de dégradation $G_1$, suivie par une impulsion $\pi/2$ de proton et ensuite en appliquant une seconde impulsion à gradient de dégradation $G_2$,
   e) irradier une impulsion $\pi/2$ agissant sur les spins S,
   f) appliquer deux champs HF ayant des amplitudes adaptées $\omega_1^I/2\pi = \omega_1^I/2\pi$ pour une polarisation croisée à une seule transition vers une seule transition, à la résonance avec une paire choisie quelconque de transitions reliées durant un second intervalle de temps $\tau_2$, les amplitudes des champs HF étant réduites par rapport aux amplitudes de l'étape b)
   g) utiliser une phase-cycle du récepteur $\Phi_{rec} = x, -x, x, -x$.

7. Procédé selon la revendication 6, **caractérisé par** l'insertion d'un temps de relaxation approprié à un moment (a) avant l'intervalle de polarisation ST-CP $\tau_2$ pour surveiller le comportement de relaxation des cohérences à spin S tout en observant les composants doublets à spin I.

8. Procédé selon la revendication 7, **caractérisé par** l'insertion d'une séquence de refocalisation multiple de Carr-Purcell-Meiboom-Gill (CPMG) au moment (a) avant l'intervalle de polarisation ST-CP $\tau_2$ pour surveiller le comportement de relaxation des cohérences à spin S tout en observant les composants doublets à spin I.

9. Procédé selon la revendication 8, utilisant une séquence d'écho de spin de Carr-Purcell-Meiboom-Gill (CPMG) pour les mesures de $T_2$, **caractérisé en ce que** les intervalles entre les impulsions $\pi$ du train d'impulsions de type CPMG sont établis à $2\tau = n/J_{IS}$, où n est un entier.

10. Procédé selon la revendication 7, **caractérisé par** l'insertion d'un champ de verrouillage de spin au moment (a) avant l'intervalle de polarisation ST-CP $\tau_2$ pour les mesures de $T_{1\rho}$.

$$\beta\beta$$

$$4$$

$$\omega_o^{(3,4)} = \omega_o^S - \pi J$$

$$3 \quad \beta\alpha$$

$$\omega_o^{(2,4)} = \omega_o^I - \pi J$$

$$\omega_o^{(1,3)} = \omega_o^I + \pi J$$

$$\alpha\beta \quad 2$$

$$\omega_o^{(1,2)} = \omega_o^S + \pi J$$

$$1$$

$$\alpha\alpha$$

$$2I_y^{(1,4)}$$

$$\left\langle I_x^{(2,4)} \right\rangle (\tau = 24 \text{ ms}) = 0.34$$

$$\sigma(0)$$

$$\omega_{eff}$$

$$2I_x^{(2,4)}$$

$$2I_x^{(1,2)}$$

$$\sigma(t)$$

$$\left\langle I_x^{(1,2)} \right\rangle (\tau = 0) = 0.5$$

$\phi_1$

$\tau_1$

$^1H$

CP

ST-CP

$\tau_2$

$\phi_2$

y

$^{15}N$

(a)

G

$G_1$

$G_2$